(19) Europäisches Patentamt / European Patent Office / Office européen des brevets

(11) EP 3 674 078 A1

(12) EUROPEAN PATENT APPLICATION
published in accordance with Art. 153(4) EPC

(43) Date of publication:
01.07.2020 Bulletin 2020/27

(21) Application number: 18847956.2

(22) Date of filing: 21.08.2018

(51) Int Cl.:
*B32B 9/00* (2006.01) *C23C 16/42* (2006.01)
*H01L 51/50* (2006.01) *H05B 33/02* (2006.01)
*H05B 33/04* (2006.01) *H05B 33/14* (2006.01)

(86) International application number:
PCT/JP2018/030790

(87) International publication number:
WO 2019/039461 (28.02.2019 Gazette 2019/09)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 25.08.2017 JP 2017162749

(71) Applicant: Sumitomo Chemical Company Limited
Tokyo 104-8260 (JP)

(72) Inventors:
- MAKIDERA, Masami
Tsukuba-shi
Ibaraki 300-3294 (JP)
- ARIMURA, Takashi
Tsukuba-shi
Ibaraki 300-3294 (JP)
- YAMASHITA, Yasuhiro
Tsukuba-shi
Ibaraki 300-3294 (JP)
- HANAOKA, Hidenori
Osaka-shi
Osaka 554-8558 (JP)

(74) Representative: J A Kemp LLP
14 South Square
Gray's Inn
London WC1R 5JJ (GB)

# (54) LAMINATE FILM

(57) A laminated film including: a substrate; and a thin film layer stacked on at least one surface of the substrate, the thin film layer containing silicon atoms, oxygen atoms, and carbon atoms, the thin film layer having at least three extrema, a difference between a maximum value of local maxima and a minimum value of the local maxima of 14 at% or less, and a maximum value of 23 at% to 33 at% in a carbon distribution curve that represents a relationship between a thickness-wise distance in the thin film layer from a surface of the thin film layer and a proportion of the number of carbon atoms (atomic proportion of carbon) to a total number of silicon atoms, oxygen atoms, and carbon atoms contained in the thin film layer at a point positioned away from the surface by the distance, and the thin film layer including at least one discontinuous region that satisfies a relationship of formulae (1) to (3),

$$3\ \text{at\%} \leq a - b \quad (1)$$

$$3\ \text{at\%} \leq b - c \quad (2)$$

$$0.5 < (a - c)/dx \quad (3).$$

EP 3 674 078 A1

FIG. 3

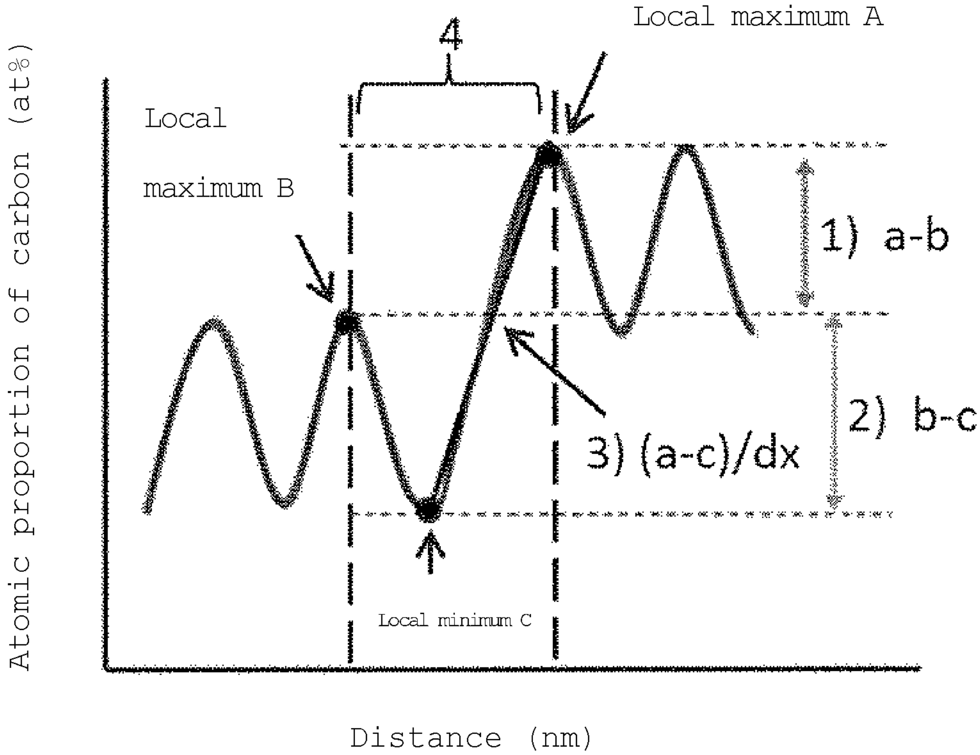
Local maximum A
4
Local
maximum B
1) a-b
2) b-c
3) (a-c)/dx
Local minimum C
Atomic proportion of carbon (at%)
Distance (nm)

**Description**

TECHNICAL FIELD

The present invention relates to a laminated film used in image display devices and the like.

BACKGROUND ART

A gas barrier film is suitably used as a packing container suitable for a package filled with an article such as drink and food, cosmetics, or a detergent. In recent years, there has been proposed a gas barrier laminated film that includes a plastic film or the like as a substrate and a thin film stacked on one surface of the substrate, with the thin film containing, as a constituent material, silicon oxide, silicon nitride, silicon oxynitride, aluminum oxide, or the like. This laminated film is being required to be widely used in electronic devices such as an organic electroluminescence (EL) element and a liquid crystal (LCD) element, and studies on this requirement are being conducted. As a method for forming such an inorganic material-containing thin film on a surface of a plastic substrate, there are known physical vapor deposition (PVD) methods such vacuum deposition, sputtering, and ion plating; and chemical vapor deposition (CVD) methods such as low-pressure chemical vapor deposition and plasma-enhanced chemical vapor deposition. For example, Patent Document 1 discloses a highly bendable laminated film that includes a thin film layer (gas barrier layer) containing silicon atoms, oxygen atoms, and carbon atoms and that has a substantially continuously changing carbon distribution curve.

PRIOR ART DOCUMENT

PATENT DOCUMENT

Patent Document 1: WO 2013/146964 A

SUMMARY OF THE INVENTION

PROBLEMS TO BE SOLVED BY THE INVENTION

The conventional laminated film, however, does not sometimes have sufficient adhesiveness between the substrate and the thin film layer and causes a crack or the like in some cases when exposed to a high-temperature and high-humidity environment for a long time.

Accordingly, an object of the present invention is to provide a laminated film having excellent adhesiveness between a substrate and a thin film layer.

MEANS FOR SOLVING THE PROBLEMS

As a result of earnest studies to attain the object, the inventor of the present invention has found that the adhesiveness between the substrate and the thin film layer is improved when, in the laminated film including the thin film layer, the thin film layer includes a prescribed discontinuous region and a carbon distribution curve has a maximum value of 23 to 33 at%. Thus, the inventor of the present invention has completed the present invention. That is, the present invention includes the following aspects.

[1] A laminated film including: a substrate; and a thin film layer stacked on at least one surface of the substrate, the thin film layer containing silicon atoms, oxygen atoms, and carbon atoms, the thin film layer having at least three extrema, a difference between a maximum value of local maxima and a minimum value of the local maxima of 14 at% or less, and a maximum value of 23 to 33 at% in a carbon distribution curve that represents a relationship between a thickness-wise distance in the thin film layer from a surface of the thin film layer and a proportion of a number of carbon atoms (atomic proportion of carbon) to a total number of silicon atoms, oxygen atoms, and carbon atoms contained in the thin film layer at a point positioned away from the surface by the distance, and the thin film layer including at least one discontinuous region that satisfies a relationship of formulae (1) to (3),

$$3\ \text{at\%} \leq a - b \quad (1)$$

$$3 \text{ at\%} \leq b - c \quad (2)$$

$$0.5 < (a - c)/dx \quad (3)$$

in the formulae (1) to (3), when thickness-wise extrema of the thin film layer that are adjacent to each other are, in the carbon distribution curve, defined as a local maximum A, a local minimum C, and a local maximum B in this order from a substrate end, a represents the atomic proportion of carbon (at%) of the local maximum A, b represents the atomic proportion of carbon (at%) of the local maximum B, c represents the atomic proportion of carbon (at%) of the local minimum C, and dx represents a distance (nm) between the local maximum A and the local minimum C.

[2] The laminated film according to [1], in which a distance X (nm) and a distance Y (nm) satisfy, in the carbon distribution curve, a relationship of a formula (4), with the distance X representing a distance from the local maximum A in the discontinuous region to an interface between the thin film layer and the substrate, and the distance Y representing a distance from the surface of the thin film layer to the interface between the thin film layer and the substrate,

$$X < Y/2 \quad (4)$$

when the thin film layer includes two or more discontinuous regions, the local maximum A represents a local maximum having a largest atomic proportion of carbon in the two or more discontinuous regions.

[3] The laminated film according to [1] or [2], in which the formula (1) is $3 \text{ at\%} \leq a - b \leq 10 \text{ at\%}$, the formula (2) is $3 \text{ at\%} \leq b - c \leq 10 \text{ at\%}$, and the formula (3) is $0.5 < (a - c)/dx < 0.8$.

EFFECT OF THE INVENTION

A laminated film according to the present invention has excellent adhesiveness between a substrate and a thin film layer.

BRIEF DESCRIPTION OF THE DRAWINGS

Fig. 1 is a schematic view illustrating one exemplary layer structure of a laminated film according to the present invention.

Fig. 2 is a schematic diagram for describing a discontinuous region in a carbon distribution curve of a thin film layer of the laminated film illustrated in Fig. 1.

Fig. 3 is an enlarged schematic diagram of the discontinuous region illustrated in Fig. 2.

Fig. 4 is a schematic view illustrating one exemplary apparatus for producing the laminated film according to the present invention.

Fig. 5 is a graph illustrating a carbon distribution curve of a thin film layer of a laminated film obtained in Example 1.

Fig. 6 is a graph illustrating a carbon distribution curve of a thin film layer of a laminated film obtained in Example 2.

Fig. 7 is a graph illustrating a carbon distribution curve of a thin film layer of a laminated film obtained in Comparative Example 1.

Fig. 8 is microscope images of the laminated films obtained in Examples 1 and 2 and Comparative Example 1.

MODE FOR CARRYING OUT THE INVENTION

A laminated film according to the present invention includes a substrate and a thin film layer stacked on at least one surface of the substrate. The thin film layer can be stacked on one surface or both surfaces of the substrate. Hereinafter, the present invention is specifically described with reference to embodiments of the laminated film according to the present invention. The present invention, however, is not to be limited to these embodiments.

[Laminated film 1]

Fig. 1 is a schematic view illustrating one exemplary layer structure of a laminated film 1 according to the present invention that includes one discontinuous region. The laminated film 1 includes, on one surface of a substrate 2, a thin film layer containing silicon atoms, oxygen atoms, and carbon atoms. The thin film layer 3 is configured to include a thin film layer 3a stacked on the substrate 2, and a thin film layer 3b stacked on the thin film layer 3a with a discontinuous region 4 interposed between the thin film layers 3a and 3b.

(Substrate 2)

The substrate 2 is a film that is flexible and contains a polymer material as a constituent material. When the laminated film has light permeability, examples of the constituent material for the substrate 2 include polyester resins such as polyethylene terephthalate (PET) and polyethylene naphthalate (PEN); polyolefin resins such as polyethylene (PE), polypropylene (PP), and a cyclic polyolefin; a polyamide resin; a polycarbonate resin; a polystyrene resin; a polyvinyl alcohol resin; a saponified product of an ethylene-vinyl acetate copolymer; a polyacrylonitrile resin; an acetal resin; and a polyimide resin. Among these resins, a polyester-based resin or a polyolefin-based resin is preferable, and polyester-based resin PET or PEN is more preferable from the viewpoints of high heat resistance and a small linear expansion coefficient. These resins can be used alone or in combination of two or more thereof.

When the light permeability of the laminated film 1 is little importance, it is also possible to use, as the substrate 2, for example, a composite material prepared by adding a filler or an additive to the resin.

The thickness of the substrate 2 is appropriately set in consideration of stability and the like in the production of the laminated film, and is preferably 5 to 500 μm for ease of transporting the substrate 2 even in a vacuum. When the thin film layer is formed by plasma-enhanced chemical vapor deposition (plasma CVD), electric discharge is performed through the substrate 2, so that the thickness of the substrate 2 is more preferably 50 to 200 μm, particularly preferably 50 to 100 μm. The substrate 2 may be subjected to a surface-active treatment for cleaning the surface of the substrate to increase the adhesive force to the thin film layer formed. Examples of such a surface-active treatment include a corona treatment, a plasma treatment, and a flame treatment.

(Thin film layer 3)

The thin film layers 3a and 3b of the thin film layer 3 each contain silicon atoms, oxygen atoms, and carbon atoms, and can further contain nitrogen atoms, aluminum atoms, or the like. Suitably, the thin film layers 3a and 3b preferably contain, as a main component, the silicon atoms, the oxygen atoms, and the carbon atoms. The main component means that the total amount of the silicon atoms, the oxygen atoms, and the carbon atoms is 90 at% (atomic%) or more, preferably 100 at% relative to the total amount (100 at%) of the atoms contained in the thin film layer.

Fig. 2 is a schematic diagram for describing the discontinuous region in a carbon distribution curve that represents a relationship between a thickness-wise distance (sometimes referred to as a distance x) in the thin film layer 3 from a surface of the thin film layer 3 (thin film layer 3b) and a proportion of the number of carbon atoms (atomic proportion of carbon) to a total number of silicon atoms, oxygen atoms, and carbon atoms contained in the film layer 3 at a point positioned away from the surface by the distance. For easy understanding, Fig. 2 shows a curve including portions corresponding to the thin film layers 3a and 3b, where a local maximum and a local minimum prescribed in each of the thin film layers regularly repeat, but an actual carbon distribution curve is a curve illustrated in Fig. 5 (Example 1) or in Fig. 6 (Example 2).

In Fig. 2, the thin film layer 3b has a relatively lower average atomic proportion of carbon than the average atomic proportion of carbon in the thin film layer 3a, and the discontinuous region 4 is present between the thin film layers 3a and 3b. That is, when the carbon distribution curve is described from a substrate 2 end toward a thin film layer 3b end, because the substrate 2 has a very high atomic proportion of carbon, the atomic proportion of carbon remarkably decreases in an interface between the substrate 2 and the thin film layer 3a. Then, the thin film layer 3a has an atomic proportion of carbon that substantially continuously changes in a relatively higher range than the range in the thin film layer 3b, and the average atomic proportion of carbon decreases in the discontinuous region 4. The thin film layer 3b has an atomic proportion of carbon that substantially continuously changes in a relatively lower range than the range in the thin film layer 3a. In the present specification, the phrase "the carbon distribution curve substantially continuously changes" indicates that the atomic proportion of carbon in the carbon distribution curve continuously increases or decreases, and means that the carbon distribution curve does not include a discontinuously changing portion, that is, the discontinuous region. Specifically, a relationship between the distance (x, unit nm) and the atomic proportion of carbon (C, at%) satisfies the condition represented by a formula (A):

$$|dC/dx| \leq 0.5 \quad (A).$$

Fig. 3 is an enlarged schematic diagram of the discontinuous region 4 illustrated in Fig. 2. The discontinuous region 4 means, as illustrated in Fig. 3, a region satisfying a relationship of formulae (1) to (3) in the carbon distribution curve:

$$3 \text{ at\%} \leq a - b \quad (1)$$

$$3 \text{ at\%} \leq b - c \quad (2)$$

$$0.5 < (a - c)/dx \quad (3)$$

[in the formulae (1) to (3), when thickness-wise extrema of the thin film layer that are adjacent to each other are, in the carbon distribution curve, defined as a local maximum A, a local minimum C, and a local maximum B in this order from a substrate end, a represents the atomic proportion of carbon (at%) of the local maximum A, b represents the atomic proportion of carbon (at%) of the local maximum B, c represents the atomic proportion of carbon (at%) of the local minimum C, and dx represents a distance (nm) between the local maximum A and the local minimum C]. The discontinuous region 4 is a region between the local maximum A (denoted as a point A) and the local maximum B (denoted as a point B). The discontinuous region 4 has a film thickness of preferably more than 0 nm and 50 nm or less, more preferably 5 to 50 nm, further preferably 10 to 45 nm, particularly preferably 20 to 45 nm, especially 30 to 45 nm.

When described from the substrate 2 end toward a surface end of the thin film layer 3 (thin film layer 3b) in the carbon distribution curve, the region of the thin film layer 3a is a region between a local minimum (local minimum D, denoted as a point D) directly after a region where the atomic proportion of carbon sharply decreases and the point A. The average atomic proportion of carbon in the thin film layer 3a is an averaged value of the atomic proportion of carbon in this region of the carbon distribution curve. The region of the thin film layer 3b is a region between the point B and a contact point of the carbon distribution curve with the ordinate of the diagram.

When the thin film layer 3a has no local minimum directly after the region where the atomic proportion of carbon sharply decreases from the atomic proportion of carbon on the substrate 2 end, the thin film layer 3a is defined as a region between a first point serving as a base and the point A. The first point is determined by: setting a point (first point) in a region that is in the vicinity of the atomic-proportion-of-carbon sharp decrease region and that has an increase in the atomic proportion of carbon observed when the distance from the surface of the thin film layer 3 is changed; setting another point (second point) obtained by changing, from the first point, the thickness-wise distance in the thin film layer 3 from the surface of the thin film layer 3, by further 20 nm; and defining the first point as the base when an absolute value of the difference in the atomic proportion of carbon between the first point and the second point is 5 at% or less. In the carbon distribution curve, the local minimum D or the first point is the interface between the thin film layer 3a and the substrate 2.

The thin film layer 3a has an average atomic proportion of carbon (at%) of preferably 15 to 30 at%, more preferably 17 to 27 at%, more preferably 18 to 25 at%. The thin film layer 3a having an average atomic proportion of carbon in the above range is advantages from the viewpoint of the adhesiveness between the substrate and the thin film layer. The thin film layer 3b has an average atomic proportion of carbon (at%) of preferably 10 to 25 at%, more preferably 13 to 20 at%, further preferably 15 to 17 at%. The thin film layer 3b having an average atomic proportion of carbon in the above range is advantageous from the viewpoints of gas barrier properties and flex resistance of the thin film layer.

The laminated film 1 having transparency may possibly decrease the transparency due to reflection and scattering caused in the interface between the substrate 2 and the thin film layer 3, when the laminated film 1 has a large difference in refractive index between the substrate 2 and the thin film layer 3. In this case, the atomic proportion of carbon in the thin film layer 3 is adjusted within the above numerical range to decrease the difference in refractive index between the substrate 2 and the thin film layer 3 and thus enable an improvement in transparency of the laminated film 1.

In the present specification, the "extremum" refers to, in the carbon distribution curve, a local maximum or a local minimum of the atomic proportion of carbon with respect to the thickness-wise distance in the thin film layer 3 from the surface of the thin film layer 3. The "local maximum" refers to a point where the atomic proportion of carbon changes from an increase to a decrease when the distance from the surface of the thin film layer 3 is changed. The "local minimum" refers to a point where the atomic proportion of carbon changes from a decrease to an increase when the distance from the surface of the thin film layer 3 is changed.

In the carbon distribution curve, the number of the extrema is at least 3, preferably 3 to 40, more preferably 10 to 35, further preferably 20 to 30, particularly preferably 25 to 30. The number of the local maxima is preferably 3 to 20, more preferably 10 to 15, and the number of the local minima is preferably 3 to 20, more preferably 10 to 15. The thin film layer having numbers of the extrema, the local maxima, and the local minima in the above ranges is capable of improving the gas barrier properties. From the view point of the gas barrier properties, three consecutive extrema in the carbon distribution curve preferably has a distance of 50 nm or less between any adjacent extrema.

The formula (1) is preferably 3 at% $\leq$ a - b $\leq$ 10 at%, more preferably 4 at% $\leq$ a - b $\leq$ 9 at%. The formula (2) is preferably 3 at% $\leq$ b - c $\leq$ 10 at%, more preferably 4 at% $\leq$ a - b $\leq$ 9 at%. The formula (3) is preferably 0.5 < (a - c)/dx < 0.8, more preferably 0.5 < (a-c)/dx < 0.7. The thin film layer including the discontinuous region 4 in these ranges is sometimes capable of improving the adhesiveness between the substrate and the thin film layer and/or the gas barrier properties.

The thin film layer 3 has, in the carbon distribution curve, a maximum value of preferably 23 to 33 at%. The maximum value is more preferably 24 at% or more, further preferably 25 at% or more, especially preferably 26 at% or more, and is more preferably 31 at% or less, further preferably 29 at%. The thin film layer having, in the carbon distribution curve, a maximum value in the above range is capable of improving the adhesiveness between the substrate 2 and the thin film layer 3 (thin film layer 3a). The maximum value in the carbon distribution curve means the largest atomic proportion of carbon in the carbon distribution curve, and means, in the laminated film 1, a local maximum having the highest atomic proportion of carbon in the thin film layer 3a.

The laminated film 1 according to the present invention has excellent adhesiveness between the substrate and the thin film layer, so that the laminated film does not cause a crack or the like even when exposed to a high-temperature and high-humidity environment for a long time. This is presumed to be because the laminated film includes, on the substrate 2 end, the thin film layer 3a having a relatively high average atomic proportion of carbon and a maximum value in the prescribed range (23 to 33 at%). The laminated film 1 according to the present invention also has high gas barrier properties and excellent bendability. This is presumed to be because the laminated film includes both the thin film layers 3a and 3b having different average atomic proportions of carbon, with the discontinuous region 4 interposed between the thin film layers.

The thin film layer 3 has, in the carbon distribution curve, a minimum value of preferably 6 to 15 at%, more preferably 9 to 11 at%. The minimum value in the carbon distribution curve means the smallest atomic proportion of carbon in the carbon distribution curve, and means, in the laminated film 1, a local minimum having the smallest atomic proportion of carbon in the thin film layer 3b.

In the carbon distribution curve, a distance X (nm) and a distance Y (nm) preferably satisfy a relationship of a formula (4), with the distance X representing a distance from the local maximum A in the discontinuous region 4 to the interface between the thin film layer and the substrate, and the distance Y representing a distance from the surface of the thin film layer to the interface between the thin film layer and the substrate:

$$X < Y/2 \quad (4).$$

The formula (4) indicates that the local maximum A of the discontinuous region 4 is present at a position closer to the substrate 2 than to the surface of the thin film layer 3. The formula (4) is more preferably Y/10 $\leq$ X < Y/2, further preferably Y/5 $\leq$ X < Y/2. The presence of the local maximum A of the discontinuous region 4 at such a position is advantageous from the viewpoint of the adhesiveness between the thin film layer 4 and the substrate 2. The carbon distribution curve in Fig. 2 has one discontinuous region. When the carbon distribution curve has two or more discontinuous regions, the local maximum A involving the formula (4) represents a local maximum having the largest atomic proportion of carbon in the two or more discontinuous regions.

The thin film layer 3 has, in the carbon distribution curve, a difference between the maximum value of the local maxima and the minimum value of the local maxima of preferably 5 at%, more preferably 7 at%, further preferably 8 at%, and preferably 14 at% or less, more preferably 13 at% or less. The thin film layer having a difference in the above range is advantageous from the viewpoints of the adhesiveness between the substrate and the thin film layer, the barrier properties, and the flex resistance. The maximum value of the local maxima represents the highest atomic proportion of carbon among the local maxima in the carbon distribution curve, and the minimum value of the local maxima represents the smallest atomic proportion of carbon among the local maxima in the carbon distribution curve.

In the laminated film 1, the thin film layer 3 has a film thickness in a range of preferably 5 nm to 3 $\mu$m, more preferably 10 nm to 2 $\mu$m, particularly preferably 100 nm to 1 $\mu$m. The thin film layer 3 having a film thickness of the above lower limit or more is capable of further improving the gas barrier properties against, for example, an oxygen gas or water vapor. The thin film layer 3 having a film thickness of the above upper limit or less gives a higher effect of minimizing the decrease in the gas barrier properties when bent. When the film thickness of the thin film layer 3 is determined, the film thicknesses of the thin film layers 3a and 3b are naturally determined according to the position of the discontinuous region 4.

(Method for creating carbon distribution curve)

The carbon distribution curve can be created by so-called XPS depth profile analysis that is performed by a combination use of measurement through X-ray Photoelectron Spectroscopy (XPS) and noble-gas ion sputtering with argon or the like to conduct sequential surface composition analysis while exposing the interior of a sample. In the distribution curve obtained by the XPS depth profile analysis, the ordinate represents the proportion of the number of carbon atoms (atomic proportion of carbon) (unit: at %), and the abscissa represents the etching time. For such XPS depth profile analysis, it is preferable to employ noble-gas ion sputtering with argon ($Ar^+$) used as an etching ion species and to set the etching speed (etching rate) at 0.05 nm/sec (in terms of $SiO_2$ thermally oxidized film). The $SiO_xC_y$ ($0 < x < 2$, $0 < y < 2$) forming the thin film layer 3 is etched faster than a $SiO_2$ thermally oxidized film is, so that the etching speed 0.05 nm/sec of the $SiO_2$ thermally oxidized film is used as an index of an etching condition. That is, the product of the etching speed 0.05 nm/sec and the etching time taken to reach the substrate 2 does not strictly represents the distance from the surface of the thin film layer 3 to the substrate 2. Therefore, the film thickness of the thin film layer 3 is separately measured, and on the basis of the measured film thickness and the etching time taken from the surface of the thin film layer 3 to the substrate 2, the etching time is made correspond to "the thickness-wise distance in the thin film layer 3 from the surface of the thin film layer 3." This procedure enables the creation of the carbon distribution curve, with the ordinate representing the atomic proportion of carbon (unit: at %), and the abscissa representing the thickness-wise distance in the thin film layer 3 from the surface of the thin film layer 3 (unit: nm).

First, the film thickness of the thin film layer 3 is measured by subjecting the thin film layer 3 to a Focused Ion Beam (FIB) process to prepare a slice of the thin film layer 3 and observing a section of the slice with TEM. Next, on the basis of the measured film thickness and the etching time taken from the surface of the thin film layer 3 to the substrate 2, the etching time is made correspond to "the thickness-wise distance in the thin film layer 3 from the surface of the thin film layer 3." In the XPS depth profile analysis, the measured atomic proportion of carbon rapidly increases when the etching region moves from the thin film layer 3 containing $SiO_2$ or $SiO_xC_y$ as a constituent material to the substrate 2 containing a polymer material as a constituent material. In the present invention, therefore, in the XPS depth profile, the time when the slope is maximum in the region where "the atomic proportion of carbon rapidly increases" is defined as the etching time corresponding to a boundary between the thin film layer 3 and the substrate 2 in the XPS depth profile analysis. When the XPS depth profile analysis is performed discretely with respect to the etching time, times are extracted that give the maximum difference in measured atomic proportion of carbon between two measurement-time adjacent points, and the midpoint between the two points is defined as the etching time corresponding to the boundary between the thin film layer 3 and the substrate 2. When the XPS depth profile analysis is performed continuously along the film thickness, a point is set that gives, in the region where "the atomic proportion of carbon rapidly increases," the maximum time derivative in a graph of the atomic proportion of carbon verses the etching time, and the point is defined as the etching time corresponding to the boundary between the thin film layer 3 and the substrate 2. That is, the film thickness of the thin film layer obtained by observing the section of the slice of the thin film layer 3 with TEM is made correspond to "the etching time corresponding to the boundary between the thin film layer 3 and the substrate 2" in the XPS depth profile to enable the creation of the carbon distribution curve, with the ordinate representing the atomic proportion of carbon, and the abscissa representing the thickness-wise distance in the thin film layer 3 from the surface of the thin film layer 3.

In the laminated film 1, the thin film layer 3 is preferably substantially uniform along a film surface of the thin film layer 3 (in parallel with the surface of the thin film layer 3) from the viewpoint of forming the thin film layer 3 having even and excellent surface wettability and gas barrier properties throughout the entire film surface of the thin film layer 3. The phrase "the thin film layer 3 is substantially uniform along a film surface" refers to a state of the thin film layer, in which when carbon distribution curves are created at any two analysis sites on the film surface of the thin film layer 3 by the XPS depth profile analysis, the carbon distribution curves obtained at the any two analysis sites have the same number of extrema, and the same absolute value of the difference between the maximum value and the minimum value of the atomic proportion of carbon or a difference of the absolute value of within 5 at% between the carbon distribution curves.

The laminated film according to the present invention has been described with reference to the laminated film 1 including one discontinuous region. The present invention is not limited to these embodiments. The thin film layer may be stacked only on one surface of the substrate as illustrated in the laminated film 1 or on both surfaces of the substrate. The number and the position(s) of the discontinuous region(s) are appropriately selected according to the laminated film aimed. The number of the discontinuous regions is preferably at least 1, more preferably 1 to 5, further preferably 1 to 3, particularly preferably 1 or 2. As described in the item Laminated film 1, the thin film layer including at least one discontinuous region and having, in the carbon distribution curve, a maximum value in the prescribed range is capable of improving the adhesiveness between the substrate and the thin film layer. Further, the thin film layer including at least two discontinuous regions at the prescribed positions is sometimes capable of improving the surface wettability of the thin film layer, in addition to the adhesiveness between the substrate and the thin film layer. Fig. 1 schematically illustrates the distribution of film composition to show the discontinuous region positioned on a surface perpendicular to the film thickness, but the discontinuous region may have a curved surface.

The thin film layer may include one or at least two layers on the substrate. When the thin film layer includes at least two layers, the plurality of thin film layers may have an identical or different carbon distribution curves. The laminated film may include the thin film layer having the discontinuous region of the present invention, and a thin film layer having no discontinuous region. When the laminated film according to the present invention includes at least two thin film layers, the total film thickness of the thin film layers is preferably more than 100 nm and 3 μm or less. The film thickness per one thin film layer is preferably more than 50 nm.

The laminated film according to the present invention includes the substrate and the thin film layer and may further include a primer coating layer, a heat-sealable resin layer, an adhesive layer, or the like as necessary. This primer coating layer can be formed with a known primer coating agent capable of improving the adhesion to the laminated film. This heat-sealable resin layer can be formed with appropriate use of a known heat-sealable resin. This adhesive layer can be formed with appropriate use of a known adhesive, and may bond a plurality of laminated films to each other.

[Method for producing laminated film]

A method for producing the laminated film according to the present invention is described below.

Fig. 4 is a schematic view illustrating one exemplary apparatus for producing the laminated film according to the present invention and for forming the thin film layer by plasma-enhanced chemical vapor deposition (plasma CVD). In Fig. 4, the dimension, the scale, and the like of each component are appropriately made different from the actual dimension, the actual scale, and the like to facilitate visualization of the drawing.

A production apparatus 10 illustrated in Fig. 4 includes a feeding roller 11, a winding-up roller 12, transport rollers 13 to 16, a first film-forming roller 17, a second film-forming roller 18, a gas supply pipe 19, a power source for plasma generation 20, an electrode 21, an electrode 22, a magnetic field-forming device 23 disposed in the first film-forming roller 17, and a magnetic field-forming device 24 disposed in the second film-forming roller 18.

When a laminated film is formed, the first film-forming roller 17, the second film-forming roller 18, the gas supply pipe 19, the magnetic field-forming device 23, and the magnetic field-forming device 24 among the components of the production apparatus 10 are disposed in a vacuum chamber not shown in the drawing. This vacuum chamber is connected to a vacuum pump not shown in the drawing. The pressure in the vacuum chamber is adjusted by operation of the vacuum pump. When this apparatus is used, control of the power source for plasma generation 20 enables, in a space between the first and second film-forming rollers 17 and 18, generation of electric discharge plasma of a film-forming gas supplied from the gas supply pipe 19. Formation of a film by plasma CVD can be performed by a continuous film-forming process with the electric discharge plasma generated.

A roll of the substrate 2 on which a film has not been formed is placed on the feeding roller 11, which feeds the substrate 2 while longitudinally winding off the substrate 2. The winding-up roller 12 is disposed at an end side of the substrate 2 and winds up the substrate 2 on which a film has been formed, while drawing the substrate 2, to recover the substrate 2 in the form of a roll. The first and second film-forming rollers 17 and 18 are arranged extensively in parallel, facing each other. Both the rollers are formed of a conductive material and each rotate to transport the substrate 2. As the first and second film-forming rollers 17 and 18, it is preferable to use rollers having the same diameter, for example, a diameter of preferably 5 cm or more and 100 cm or less.

The first and second film-forming roller 17 and 18 are insulated from each other and connected to the power source for plasma generation 20 in common use. When alternating voltage is applied from the power source for plasma generation 20, an electric field is formed in a space SP between the first and second film-forming rollers 17 and 18. As the power source for plasma generation 20, a power source is preferable that enables a power application of 100 W to 10 kW and an alternating current frequency of 50 Hz to 500 kHz.

The magnetic field-forming devices 23 and 24 are members for forming a magnetic field in the space SP, and housed in the first and second film-forming rollers 17 and 18, respectively. The magnetic field-forming devices 23 and 24 are fixed so as not to rotate together with the first and second film-forming rollers 17 and 18 (that is, so as not to change their relative orientation with respect to the vacuum chamber).

The magnetic field-forming devices 23 and 24 include central magnets 23a and 24a that extend in the same direction as the extending direction of the first and second film-forming rollers 17 and 18; and annular outside magnets 23b and 24b that are arranged extensively in the same direction as the extending direction of the first and second film-forming rollers 17 and 18 while surrounding peripheries of the central magnets 23a and 24a. In the magnetic field-forming device 23, a magnetic line (magnetic field) connecting the central magnet 23a to the outside magnet 23b forms an endless tunnel. Similarly, also in the magnetic field-forming device 24, a magnetic line connecting the central magnet 24a to the outside magnet 24b forms an endless tunnel. These magnetic lines intersect with the electric field formed between the first and second film-forming rollers 17 and 18 to generate magnetron discharge, which generates the electric discharge plasma of a film-forming gas. That is, as described later in detail, while the space SP is used as a film-forming space for formation of a film by plasma CVD, a film-forming gas having undergone a plasma state is deposited to form a thin film layer on a surface (film formation surface) in no contact with the first and second film-forming rollers 17 and 18, of the substrate 2. In the vicinity of the space SP is disposed the gas supply pipe 19 for supplying, to the space SP, a film-forming gas G such as a raw material gas for the plasma CVD. The gas supply pipe 19 is in the form of a pipe extending in the identical direction with the extending direction of the first and second film-forming rollers 17 and 18, and supplies the film-forming gas G to the space SP from openings provided at a plurality of sites of the gas supply pipe. Fig. 2 illustrates, by an arrow, a state where the film-forming gas G is supplied from the gas supply pipe 19 to the space SP.

The raw material gas can be appropriately selected and used according to the material for the thin film layer formed. As the raw material gas, for example, an organic silicon compound containing silicon can be used. Examples of such an organic silicon compound include hexamethyldisiloxane, 1,1,3,3-tetramethyldisiloxane, vinyltrimethylsilane, methyltrimethylsilane, hexamethyldisilane, methylsilane, dimethylsilane, trimethylsilane, diethylsilane, propylsilane, phenylsilane, vinyltriethoxysilane, vinyltrimethoxysilane, tetramethoxysilane, tetraethoxysilane, phenyltrimethoxysilane, methyltriethoxysilane, octamethylcyclotetrasiloxane, dimethyldisilazane, trimethyldisilazane, tetramethyldisilazane, pentamethyldisilazane, and hexamethyldisilazane. Among these organic silicon compounds, hexamethyldisiloxane and 1,1,3,3-tetrametyldisiloxane are preferable from the viewpoints of ease of handling the compound, and the adhesiveness, the gas barrier properties, and the like of the thin film layer obtained. These organic silicon compounds can be used alone or in combination of two or more thereof. Further, a gas containing, in addition to the organic silicon compound, monosilane may be used as the raw material gas, with monosilane used as a silicon source of the thin film layer formed.

As the film-forming gas, a reactant gas may be used in addition to the raw material gas. As this reactant gas, a gas can be appropriately selected and used that reacts with the raw material gas to turn into an inorganic compound such as an oxide or a nitride. As the reactant gas for forming an oxide, for example, oxygen or ozone can be used. As the reactant gas for forming a nitride, for example, nitrogen or ammonia can be used. These reactant gasses can be used alone or in combination of two or more thereof. For example, when an oxynitride is formed, a reactant gas for forming an oxide and a reactant gas for forming a nitride can be used in combination.

The film-forming gas may contain a carrier gas as necessary to supply the raw material gas into the vacuum chamber. As the film-forming gas, a gas for electric discharge can be used as necessary to generate the electric discharge plasma. As such a carrier gas and a gas for electric discharge, a known gas can be appropriately used. For example, noble gasses such as helium, argon, neon, and xenon; and hydrogen can be used.

The pressure (degree of vacuum) in the vacuum chamber can be appropriately adjusted according to, for example, the type of the raw material gas, and the space SP preferably has a pressure of 0.1 to 50 Pa. When low-pressure plasma CVD is used as the plasma CVD to minimize a gas-phase reaction, the space SP generally has a pressure of 0.1 Pa to 10 Pa. The power of an electrode drum in a plasma-generating device can be appropriately adjusted according to, for example, the type of the raw material gas and the pressure in the vacuum chamber, and the power is preferably 0.1 to 10 kW.

The transport speed (line speed) of the substrate 2 may be appropriately adjusted according to, for example, the type of the raw material gas and the pressure in the vacuum chamber, and is preferably 0.1 to 100 m/min, more preferably 0.5 to 20 m/min. When the line speed is less than the lower limit, the substrate 2 tends to easily generate a wrinkle attributed to heat. On the other hand, when the line speed is more than the upper limit, the film thickness of the thin film layer formed tends to be decreased.

The production apparatus 10 described above forms a film on the substrate 2 as described below. First, a pretreatment should be performed before formation of a film, to sufficiently reduce outgas generated from the substrate 2. The amount of the outgas generated from the substrate 2 can be determined by the pressure obtained when the substrate 2 is mounted on the production apparatus and the apparatus (chamber) is depressurized. For example, when the pressure in the chamber for the production apparatus is $1 \times 10^{-3}$ Pa or less, the amount of the outgas generated from the substrate 2 can be determined to have been sufficiently reduced. Examples of a method for reducing the amount of the outgas generated from the substrate 2 include drying methods such as vacuum drying, heat drying, drying in combination of these methods, and natural drying. With any of the drying methods used, in order to accelerate the drying of the interior of the substrate 2 wound up in the form of a roll, it is preferable to repeat rewinding (winding off and winding up) of the roll during the drying and thus to expose the whole of the substrate 2 to a drying environment.

The vacuum drying is performed by putting the substrate 2 in a pressure-resistant vacuum container and evacuating the vacuum container with a pressure reducer such as a vacuum pump to make a vacuum state. The pressure in the vacuum container during the vacuum drying is preferably 1000 Pa or less, more preferably 100 Pa or less, further preferably 10 Pa or less. The evacuation of the vacuum container may be continuously performed by continuously operating the pressure reducer. Alternatively, the evacuation may be intermittently performed by intermittently operating the pressure reducer while controlling the internal pressure not to be a certain level or higher. The drying time is preferably 8 hours or more, more preferably 1 week or more, further preferably 1 month or more.

The heat drying is performed by exposing the substrate 2 to a 50°C or higher environment. The heating temperature is preferably 50 to 200°C, further preferably 70 to 150°C. When the heating temperature is higher than 200°C, the substrate 2 may possibly be deformed. Further, an oligomer component may possibly be eluted from the substrate 2 and precipitated on the surface of the substrate to cause a defect. The drying time can be appropriately selected according to the heating temperature and heating means used. Heating means is not particularly limited as long as the heating means is capable of heating the substrate 2 to 50 to 200°C at normal pressure. Among generally known devices, an infrared heating device, a microwave heating device, or a heating drum is preferably used.

The infrared heating device is a device for heating a subject by emitting infrared from infrared-generating means. The microwave heating device is a device for heating a subject by emitting a microwave from microwave-generating means. The heating drum is a device for heating a subject by heating a surface of a drum and bringing a subject into contact with the surface of the drum to heat the subject from the contact part by heat conduction.

The natural drying is performed by disposing the substrate 2 in a low-humidity atmosphere and allowing a flow of a dry gas (dry air or dry nitrogen) to maintain the low-humidity atmosphere.

In the natural drying, a desiccant such as silica gel is preferably disposed together in the low-humidity environment for disposing the substrate 2.

The drying time is preferably 8 hours or more, more preferably 1 week or more, further preferably 1 month or more. These drying methods may be performed separately before the substrate 2 is mounted on the production apparatus, or may be performed in the production apparatus after the substrate 2 is mounted on the production apparatus.

Examples of a method for drying the substrate 2 after mounting the substrate on the production apparatus include depressurizing the chamber while feeding and transporting the substrate 2 from the feeding roller. Alternatively, the roller that allows the substrate to pass may include a heater and heat the substrate while heated and used as the aforementioned heating drum.

Examples of another method for reducing the outgas from the substrate 2 include forming an inorganic film in advance on the surface of the substrate 2. Examples of a method for forming the inorganic film include physical film-forming methods such as vacuum deposition (heating deposition), electron beam (EB) deposition, sputtering, and ion plating.

The inorganic film may also be formed by a chemical deposition method such as thermal CVD, plasma CVD, or atmospheric pressure CVD. Further, the substrate 2 on the surface of which the inorganic film has been formed may be subjected to a drying treatment by the aforementioned drying methods to further reduce the influence of the outgas.

Next, the interior of the vacuum chamber not shown in the drawing is made into a reduced-pressure environment, and power is applied to the first and second film-forming rollers 17 and 18 to generate an electric field in the space SP. At this time, in the magnetic field-forming devices 23 and 24, the aforementioned endless tunnel-shaped magnetic fields are formed, so that introduction of the film-forming gas brings the magnetic fields and electrons released into the space SP into formation of donut-shaped electric discharge plasma of the film-forming gas along the tunnels. This electric discharge plasma can be generated by a low pressure of approximately several Pa, so that the temperature in the vacuum chamber can be set approximately at room temperature.

Meanwhile, the electrons trapped at a high density in the magnetic fields formed by the magnetic field-forming devices 23 and 24 have a high temperature, so that collision between the electrons and the film-forming gas generates the electric discharge plasma. That is, the electrons are trapped in the space SP by the magnetic fields and the electric field that are formed in the space SP, to form high-density electric discharge plasma in the space SP. In more detail, the high-density (high-intensity) electric discharge plasma is formed in an overlapping space of the electric field with the endless tunnel-shaped magnetic fields, and low-density (low-intensity) electric discharge plasma is formed in a nonoverlapping space of the electric field with the endless tunnel-shaped magnetic fields. These intensities of electric discharge plasma usually continuously change. The generation of the electric discharge plasma generates many radicals and ions to allow a plasma reaction to progress and thus generate a reaction between the raw material gas and the reactant gas that are contained in the film-forming gas. For example, the raw material gas, the organic silicon compound reacts with the reactant gas, oxygen to generate an oxidation reaction of the organic silicon compound. Here, the space where the high-intensity electric discharge plasma is formed makes it easy for the reaction to progress due to a large amount of energy applied to the oxidation reaction and is likely to mainly generate a complete oxidation reaction of the organic silicon compound. On the other hand, the space where the low-intensity electric discharge plasma is formed makes it difficult for the reaction to progress due to a small amount of energy applied to the oxidation reaction and is likely to mainly generate an incomplete oxidation reaction of the organic silicon compound. In the present specification, "the complete oxidation reaction of the organic silicon compound" refers to a reaction of oxidatively decomposing the organic silicon compound into silicon dioxide ($SiO_2$), water, and carbon dioxide along with the progress of the reaction between the organic silicon compound and oxygen.

For example, the film-forming gas containing the raw material gas, hexamethyldisiloxane (HMDSO: $(CH_3)_6Si_2O$) and the reactant gas, oxygen ($O_2$) causes, as the "complete oxidation reaction," a reaction represented by a reaction formula (6) to produce silicon dioxide.

$$(CH_3)_6Si_2O + 12O_2 \rightarrow 6CO_2 + 9H_2O + 2SiO_2 \quad (6)$$

In the present specification, "the incomplete oxidation reaction of the organic silicon compound" refers to a reaction of not allowing the complete oxidation reaction of the organic silicon compound to generate not $SiO_2$ but $SiO_xC_y$ ($0 < x < 2$, $0 < y < 2$) containing carbon in its structure.

As described above, in the production apparatus 10, the electric discharge plasma in the form of a donut is formed on the surfaces of the first and second film-forming rollers 17 and 18, so that the substrate 2 transported onto the surfaces of the first and second film-forming rollers 17 and 18 alternately passes through the space where the high-intensity electric discharge plasma is formed and the space where the low-intensity electric discharge plasma is formed. Therefore, the substrate 2, which passes the surfaces of the first and second film-forming rollers 17 and 18, alternately includes, on the surface of the substrate, a portion containing a large amount $SiO_2$ generated by the complete oxidation reaction and a portion containing a large amount of $SiO_xC_y$ generated by the incomplete oxidation reaction. That is, a thin film layer is formed that alternately includes a portion where the complete oxidation reaction easily progresses and which has a small content of carbon atoms, and a portion where the incomplete oxidation reaction easily progresses and which has a large content of carbon atoms. Therefore, the thin film layer comes to have a carbon distribution curve having extrema (local maximum and local minimum).

The local minimum (local minima), the local maximum (local maxima), the minimum value, and the maximum value (sometimes collectively referred to as a value X) in the carbon distribution curve can be adjusted by changing the ratio between the reactant gas and the raw material gas supplied. For example, an increase in the ratio of the reactant gas to the raw material gas decreases the average atomic proportion of carbon to enable a decrease of the value X. This is because the relative decrease in the amount of the raw material gas makes the reaction conditions closer to the reaction conditions for easily generating the complete oxidation of the raw material gas. On the other hand, a decrease in the ratio of the reactant gas to the raw material gas increases the average atomic proportion of carbon to enable an increase of the value X. This is because the relative increase in the amount of the raw material gas creates the reaction conditions for easily generating the incomplete oxidation of the raw material gas. Alternatively, an increase in the total amount of the film-forming gas without changing the ratio of the reactant gas to the raw material gas increases the average atomic proportion of carbon to enable an increase of the value X. This is because when the total amount of the film-forming gas is large, the energy obtained by the raw material gas from the electric discharge plasma is relatively reduced to create the reaction conditions for easily generating the incomplete oxidation of the raw material gas. Here, examples of a method for increasing the ratio of the reactant gas to the raw material gas include a method for decreasing only the amount of the raw material gas, a method for decreasing the amount of the raw material gas and increasing the amount of the reactant gas, and a method for increasing only the amount of the reactant gas. A method for increasing only the amount of the reactant gas is preferable from the viewpoint of productivity. Thus, the ratio between the reactant gas and the raw material gas is appropriately adjusted to enable, in the carbon distribution curve, adjustment of the local minimum (local minima), the local maximum (local maxima), the maximum value, and the minimum value in the prescribed ranges.

One exemplary method for producing the laminated film 1 (Figs. 1 and 2) is described.

The laminated film 1 can be produced with the apparatus illustrated in Fig. 4 preferably by the aforementioned plasma CVD. First, the thin film layer 3a having a relatively higher average atomic proportion of carbon than the average in the thin film layer 3b is formed on the substrate 2 by the plasma CVD. The thin film layer 3a preferably has a relatively high atomic proportion of carbon and a large maximum value (23 to 33 at%) in the carbon distribution curve, so that a ratio of the reactant gas is used that makes the incomplete oxidation reaction of the raw material gas advantageously progress.

Therefore, a flow ratio ($V_2/V_1$) between a volume flow $V_2$ of the reactant gas and a volume flow $V_1$ of the raw material gas that are supplied to the space SP between the pair of film-forming rollers 19 and 20 is preferably 0.10 to $0.80P_0$, more preferably 0.15 to $0.70P_0$, further preferably 0.20 to $0.60P_0$, with $P_0$ representing a minimum flow ratio ($V_{02}/V_{01}$) between a volume flow $V_{02}$ of the reactant gas and a volume flow $V_{01}$ of the raw material gas that are necessary for the complete oxidation of the organic silane compound contained in the raw material gas. The film-forming gas having a flow ratio $V_2/V_1$ in the above range is capable of improving the adhesiveness between the substrate and the thin film layer.

Next, the thin film layer 3b having a relatively lower atomic proportion of carbon than the atomic proportion of carbon in the thin film layer 3a is formed on the thin film layer 3a by the plasma CVD, with the discontinuous region 4 interposed between the thin film layers 3a and 3b. The thin film layer 3b is formed by increasing the ratio of the reactant gas to the raw material gas compared with when the thin film layer 3a is formed. At this time, the average atomic proportion of carbon is decreased between the thin film layers 3a and 3b to form the discontinuous region 4. In the formation of the thin film layer 3b, a flow ratio ($V_4/V_3$) between a volume flow $V_4$ of the reactant gas and a volume flow $V_3$ of the raw material gas that are supplied to the space between the pair of film-forming rollers 19 and 20 is preferably 0.5 to $1.2P_0$, more preferably 0.6 to $1.0P_0$, further preferably 0.7 to $0.9P_0$, with $P_0$ representing a minimum flow ratio ($V_{02}/V_{01}$) between a volume flow $V_{02}$ of the reactant gas and a volume flow $V_{01}$ of the raw material gas that are necessary for the complete oxidation of the organic silane compound contained in the raw material gas. The film-forming gas having a flow ratio $V_4/V_3$ in the above range is advantageous from the viewpoints of gas barrier properties and the flex resistance of the thin film layer. Here, the above upper limit is more than the ratio of the reactant gas theoretically necessary for the complete oxidation of the raw material gas. The reason for this is considered to be as follows: in the actual reaction of the CVD chamber, the film-forming gas is supplied from the gas supply pipe to the film-forming region to form a film, so that the progress of the complete oxidation reaction is not realistically allowed even when the film-forming gas satisfies the ratio of the reactant gas (when the raw material gas is hexamethyldisiloxane and the reactant gas is oxygen, former : latter = 1 mol : 12 mol) that is theoretically necessary for the complete oxidation of the raw material gas, and thus the reaction is completed only when an excessively large content of the reactant gas is supplied compared with the stoichiometric proportion.

As described above, the discontinuous region can be formed by increasing the ratio of the reactant gas to the raw material gas by the prescribed ratio. With the supply of the raw material gas constant, the volume flow of the reactant gas during the formation of the thin film layer 3b is preferably 1.2 to 4 times, more preferably 1.3 to 3.5 times, further preferably 1.5 to 3 times the volume flow of the reactant gas during the formation of the thin film layer 3a. The film-forming gas having, during the formation of the thin film layer 3b, a volume flow of the reactant gas in the above magnification range is capable of improving the adhesiveness between the substrate and the thin film layer.

In the formation of the thin film layers 3a and 3b, the flow of the raw material gas is, at 0°C and 1 atmosphere basis, preferably 10 to 1000 sccm, more preferably 20 to 500 sccm, further preferably 30 to 100 sccm. The flow of the reactant gas, preferably an oxygen gas can be selected according to the type and the flow of the raw material gas, in consideration of $V_2/V_1$ or $V_4/V_3$, and is, at 0°C and 1 atmosphere basis, preferably 50 to 1500 sccm, more preferably 100 to 1000 sccm, further preferably 150 to 500 sccm.

In the formation of the thin film layers 3a and 3b, parameters other than the supply of the raw material gas and the supply of the reactant gas such as oxygen may be identical or different. The other parameters are, for example, the degree of vacuum in the vacuum chamber, the power applied from the power source for plasma generation, the frequency of the power source for plasma generation, and the transport speed of the film. The position of the discontinuous region can be adjusted by controlling the timing of increasing the ratio of the reactant gas.

For example, when the laminated film 1 is produced by changing only the ratio of the reactant gas to form the discontinuous region 4, making the time for forming the thin film layer 3a shorter than the time for forming the thin film layer 3b enables the production of the laminated film 1 satisfying the relationship of the formula (4) ($X < Y/2$).

In the aforementioned one embodiment of the laminated film 1, the laminated film 1 includes the discontinuous region 4 formed by increasing the ratio of the reactant gas once, but two or more discontinuous regions can also be formed by increasing the ratio of the reactant gas twice or more times.

[Display device]

The laminated film according to the present invention can be used in display devices. The display device is a device having a display mechanism and includes, as a light emitting source, a light emitting element or a light emitting device. Examples of the display device include a liquid crystal display device, an organic electroluminescence (EL) display device, an inorganic electroluminescence (EL) display device, a touch panel display device, an electron emission display device (a field emission display device (FED, etc.) and a surface-conduction electron-emitter display device (SED)), electronic paper (a display device including electronic ink or an electrophoretic element), a plasma display device, a projection-type display device (e.g., a grating light valve (GLV) display device and a display device including a digital micromirror device (DMD)), and a piezoelectric ceramic display device. The liquid crystal display device includes all of a transmission-type liquid crystal display device, a semi-transmission-type liquid crystal display device, a reflection-type liquid crystal display device, a direct-view-type liquid crystal display device, and a projection-type liquid crystal display device. These display devices may be display devices for displaying a two-dimensional image or may be stereoscopic display devices for displaying a three-dimensional image. Particularly, the display device including the laminated film according to the present invention is preferably an organic EL display device and a touch panel display device, particularly preferably an organic EL display device.

EXAMPLES

Hereinafter, the present invention is more specifically described by way of examples and a comparative example. The present invention, however, is not to be limited to the following examples. As the measurement values of the laminated films, the values measured by the following methods were employed.

[Measurement methods]

(1) Wet heat resistance test

Laminated films A to C were each cut out into a size of 5-cm square with lever-controlled sample cutter SDL-100 (manufactured by DUMBBELL CO., LTD.) equipped with a super straight cutter (manufactured by DUMBBELL CO., LTD.).

The cut-out laminated films were stored for 48 hours in a thermohygrostat at 85°C and 85 %RH, and then a central portion of each of the laminated films A to C was observed (magnification: 35 times) with a microscope (manufactured by Hirox Co., Ltd., HIROX DIGITAL MICROSCOPE KH-7700) to determine the presence or absence of a crack. The evaluation was performed by an evaluation method of classifying one with a crack as ○ and one without a crack as ×.

(2) Measurement of film thickness of thin film layer

The film thickness of the thin film layer was obtained by observing a section of a slice of the thin film layer produced by a Focused Ion Beam (FIB) process, with a transmission electron microscope (manufactured by JEOL Ltd., JEM-2200FS).

(FIB conditions)

- Apparatus: FB2200 (manufactured by Hitachi High-Technologies Corporation)
- Acceleration voltage: 40 kV

(3) Carbon distribution curve of thin film layer

The carbon distribution curve of the thin film layer of the laminated film was created by performing XPS depth profile analysis on the thin film layer under the following conditions, and making the analysis results into a graph with the abscissa representing the distance (nm) from the surface of the thin film layer and the ordinate representing the atomic percentage of the carbon element (atomic proportion of carbon).

(Measurement conditions)

Etching ion species: argon ($Ar^+$)
Etching rate (in terms of $SiO_2$ thermally oxidized film): 0.05 nm/sec
Etching interval (in terms of $SiO_2$ thermally oxidized film): 3 nm
X-ray photoelectron spectrometer: manufactured by ULVAC-PHI, Inc., Quantera SXM
X-ray radiation: single-crystal spectroscopy AlK$\alpha$
Spot shape and diameter of X-ray: circle, 100 $\mu$m

[Example 1]

The following laminated film (laminated film A) was produced by the production apparatus illustrated in Fig. 4. The layer structure of the laminated film A is the same as the layer structure illustrated in Fig. 1.

A biaxially stretched polyethylene naphthalate film (PEN film, thickness: 100 $\mu$m, width: 350 mm, manufactured by DuPont Teijin Films, trade name "Teonex Q65FA") was used as the substrate (substrate 2), and the substrate was mounted on the feeding roller 11. Then, the film-forming gas (a mixed gas of the raw material gas (HMDSO) and the reactant gas (oxygen gas)) was supplied to the space between the first and second film-forming rollers 17 and 18 where the endless tunnel-shaped magnetic fields were formed. Power was supplied to the first and second film-forming rollers 17 and 18 to cause electric discharge between the first and second film-forming rollers 17 and 18 and the plasma CVD was performed for 5 minutes under the following film-forming conditions 1 to form, on the substrate 2, the thin film layer 3a having a relatively high atomic proportion of carbon. Then, the plasma CVD was performed for 12 minutes under the following film-forming conditions 2 to form, on the thin film layer 3a, the thin film layer 3b having a relatively low atomic proportion of carbon, with the discontinuous region 4 interposed between the thin film layers 3a and 3b. Thus, the laminated film A having one discontinuous region 4 was obtained. Fig. 5 illustrates the carbon distribution curve of the laminated film A. In the carbon distribution curve, a portion corresponding to the thin film layer 3a gave an average atomic proportion of carbon of 24 at%, a portion corresponding to the thin film layer 3b gave an average atomic proportion of carbon of 17 at%, the number of local minima was 14, the number of local maxima was 14, the discontinuous region 4 had a film thickness of 35 nm, and X and Y satisfied the formula X = Y/3.8 [in the formula, X (nm) represents the distance from the local maximum A in the discontinuous region 4 to the interface between the thin film layer 3a and the substrate 2, and Y (nm) represents the distance from the surface of the thin film layer 3b to the interface between the thin film layer 3a and the substrate 2]. The laminated film A had a film thickness of 100.344 μm.

(Film-forming conditions 1)

Supply of raw material gas (HMDSO): 50 sccm (at 0°C and 1 atmosphere basis)
Supply of oxygen gas: 150 sccm (at 0°C and 1 atmosphere basis)
Degree of vacuum in vacuum chamber: 1 Pa
Power applied from power source for plasma generation: 0.4 kW
Frequency of power source for plasma generation: 70 kHz
Transport speed of film: 0.8 m/min
Number of passes: 1

(Film-forming conditions 2)

Supply of raw material gas (HMDSO): 50 sccm (at 0°C and 1 atmosphere basis)
Supply of oxygen gas: 500 sccm (at 0°C and 1 atmosphere basis)
Degree of vacuum in vacuum chamber: 1 Pa
Power applied from power source for plasma generation: 0.4 kW
Frequency of power source for plasma generation: 70 kHz
Transport speed of film: 1.0 m/min
Number of passes: 3

[Example 2]

The laminated film (laminated film B) including one discontinuous region 4 was obtained similarly to in Example 1 except that the film-forming conditions 1 and 2 were changed to the following film-forming conditions 3 and 4. The layer structure of the laminated film B is the same as the layer structure illustrated in Fig. 1. Fig. 6 illustrates the carbon distribution curve of the laminated film B obtained. In the carbon distribution curve, a portion corresponding to the thin film layer 3a gave an average atomic proportion of carbon of 19 at%, a portion corresponding to the thin film layer 3b gave an average atomic proportion of carbon of 17 at%, the number of local minima was 15, the number of local maxima was 15, the discontinuous region 4 had a film thickness of 35 nm, and X and Y satisfied the formula X = Y/2.7 [in the formula, X (nm) represents the distance from the local maximum A in the discontinuous region 4 to the interface between the thin film layer 3a and the substrate 2, and Y (nm) represents the distance from the surface of the thin film layer 3b to the interface between the thin film layer 3a and the substrate 2]. The laminated film B had a film thickness of 100.403 μm.

(Film-forming conditions 3)

Supply of raw material gas (HMDSO): 50 sccm (at 0°C and 1 atmosphere basis)
Supply of oxygen gas: 300 sccm (at 0°C and 1 atmosphere basis)
Degree of vacuum in vacuum chamber: 1 Pa
Power applied from power source for plasma generation: 0.4 kW
Frequency of power source for plasma generation: 70 kHz
Transport speed of film: 1.0 m/min
Number of passes: 2

(Film-forming conditions 4)

Supply of raw material gas (HMDSO): 50 sccm (at 0°C and 1 atmosphere basis)
Supply of oxygen gas: 500 sccm (at 0°C and 1 atmosphere basis)
Degree of vacuum in vacuum chamber: 1 Pa
Power applied from power source for plasma generation: 0.4 kW
Frequency of power source for plasma generation: 70 kHz
Transport speed of film: 1.0 m/min
Number of passes: 3

[Comparative Example 1]

The following laminated film (laminated film C) was produced by the production apparatus illustrated in Fig. 4.

A biaxially stretched polyethylene naphthalate film (PEN film, thickness: 100 μm, width: 350 mm, manufactured by DuPont Teijin Films, trade name "Teonex Q65FA") was used as the substrate (substrate 2), and the substrate was mounted on the feeding roller 11. Then, the film-forming gas (a mixed gas of the raw material gas (HMDSO) and the reactant gas (oxygen gas)) was supplied to the space between the first and second film-forming rollers 17 and 18 where the endless tunnel-shaped magnetic fields were formed. Power was supplied to the first and second film-forming rollers 17 and 18 to cause electric discharge between the first and second film-forming rollers 17 and 18 and the plasma CVD was performed for 20 minutes under the following film-forming conditions 5 to form a thin film layer on the substrate. Thus, the laminated film C including no discontinuous region was obtained. Fig. 7 illustrates the carbon distribution curve of the laminated film C. In the carbon distribution curve, the average atomic proportion of carbon was 16 at%, the number of local minima was 19, and the number of local maxima was 19. The laminated film C had a film thickness of 100.418 μm.

(Film-forming conditions 5)

Supply of raw material gas (HMDSO): 50 sccm (at 0°C and 1 atmosphere basis)
Supply of oxygen gas: 500 sccm (at 0°C and 1 atmosphere basis)
Degree of vacuum in vacuum chamber: 1 Pa
Power applied from power source for plasma generation: 0.4 kW
Frequency of power source for plasma generation: 70 kHz
Transport speed of film: 0.8 m/min
Number of passes: 4

On the basis of the carbon distribution curves of the laminated films A to C obtained in Examples 1 and 2 and Comparative Example 1, calculated were the values of the formula (1) a - b, the formula (2) b - c, and the formula (3) (a - c)/dx that are serving as the conditions for the discontinuous region, and the difference between the maximum value and the minimum value of the local maxima, the maximum value (the maximum value of the local maxima), and the minimum value (the minimum value of the local minima). Tables 1 and 2 show the results. Table 2 also shows the presence or absence of a crack on the laminated films A to C that underwent the wet heat resistance test. Fig. 8 shows microscope images.

[Table 1]

| | Conditions for discontinuous region | | | Maximum value of local maxima | Minimum Value of local maxima | Difference between maximum value and minimum value of local maxima |
|---|---|---|---|---|---|---|
| | (a-c) /dx | a-b | b-c | | | |
| Example 1 | 0.6642 | 9at% | 8at% | 31at% | 18at% | 13at% |
| Example 2 | 0.5995 | 5at% | 8at% | 27at% | 19at% | 8at% |
| Comparative Example 1 | 0.4126 | -2at% | 10at% | 21at% | 13at% | 8at% |

[Table 2]

| | Maximum value | Minimum value | Result of wet heat resistance test |
|---|---|---|---|
| Example 1 | 31at% | 9at% | ○ |
| Example 2 | 27at% | 10at% | ○ |
| Comparative Example 1 | 21at% | 6at% | × |

As shown by Table 1, the laminated bodies A and B obtained in Examples 1 and 2 were confirmed to have high adhesiveness between the substrate and the thin film layer and thus not to generate a crack even when exposed to the wet heat resistance environment.

DESCRIPTION OF REFERENCE SIGNS

1: Laminated film
2: Substrate
3, 3a, 3b: Thin film layer
4: Discontinuous region
10: Production apparatus
11: Feeding roller
12: Winding-up roller
13 to 16: Transport roller
17: First film-forming roller
18: Second film-forming roller
19: Gas supply pipe
20: Power source for plasma generation
23, 24: Magnetic field-forming device
2: Substrate (film)
SP: Space (film-forming space)

## Claims

**1.** A laminated film comprising:

a substrate; and
a thin film layer stacked on at least one surface of the substrate, the thin film layer containing silicon atoms, oxygen atoms, and carbon atoms, the thin film layer having at least three extrema, a difference between a maximum value of local maxima and a minimum value of the local maxima of 14 at% or less, and a maximum value of 23 to 33 at% in a carbon distribution curve that represents a relationship between a thickness-wise distance in the thin film layer from a surface of the thin film layer and a proportion of a number of carbon atoms (atomic proportion of carbon) to a total number of silicon atoms, oxygen atoms, and carbon atoms contained in the thin film layer at a point positioned away from the surface by the distance, and the thin film layer including at least one discontinuous region that satisfies a relationship of formulae (1) to (3),

$$3\ \text{at\%} \leq a - b \quad (1)$$

$$3\ \text{at\%} \leq b - c \quad (2)$$

$$0.5 < (a - c)/dx \quad (3)$$

in the formulae (1) to (3), when thickness-wise extrema of the thin film layer that are adjacent to each other are, in the carbon distribution curve, defined as a local maximum A, a local minimum C, and a local maximum B in this order from a substrate end, a represents the atomic proportion of carbon (at%) of the local maximum A, b represents the atomic proportion of carbon (at%) of the local maximum B, c represents the atomic proportion of carbon (at%) of the local minimum C, and dx represents a distance (nm) between the local maximum A and the local minimum C.

**2.** The laminated film according to claim 1, wherein a distance X (nm) and a distance Y (nm) satisfy, in the carbon distribution curve, a relationship of a formula (4), with the distance X representing a distance from the local maximum A in the discontinuous region to an interface between the thin film layer and the substrate, and the distance Y representing a distance from the surface of the thin film layer to the interface between the thin film layer and the substrate,

$$X < Y/2 \quad (4)$$

when the thin film layer includes two or more discontinuous regions, the local maximum A represents a local maximum having a largest atomic proportion of carbon in the two or more discontinuous regions.

**3.** The laminated film according to claim 1 or 2, wherein the formula (1) is 3 at% $\leq$ a - b $\leq$ 10 at%, the formula (2) is 3 at% $\leq$ b - c $\leq$ 10 at%, and the formula (3) is 0.5 < (a - c)/dx < 0.8.

FIG. 1

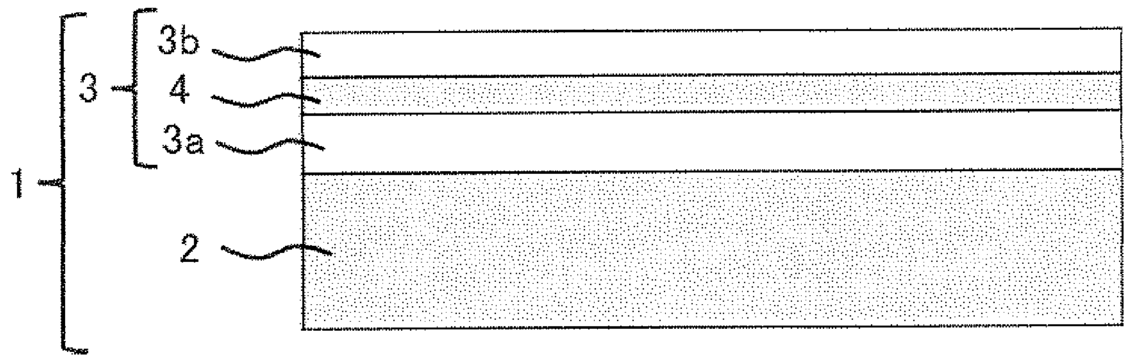

FIG. 2

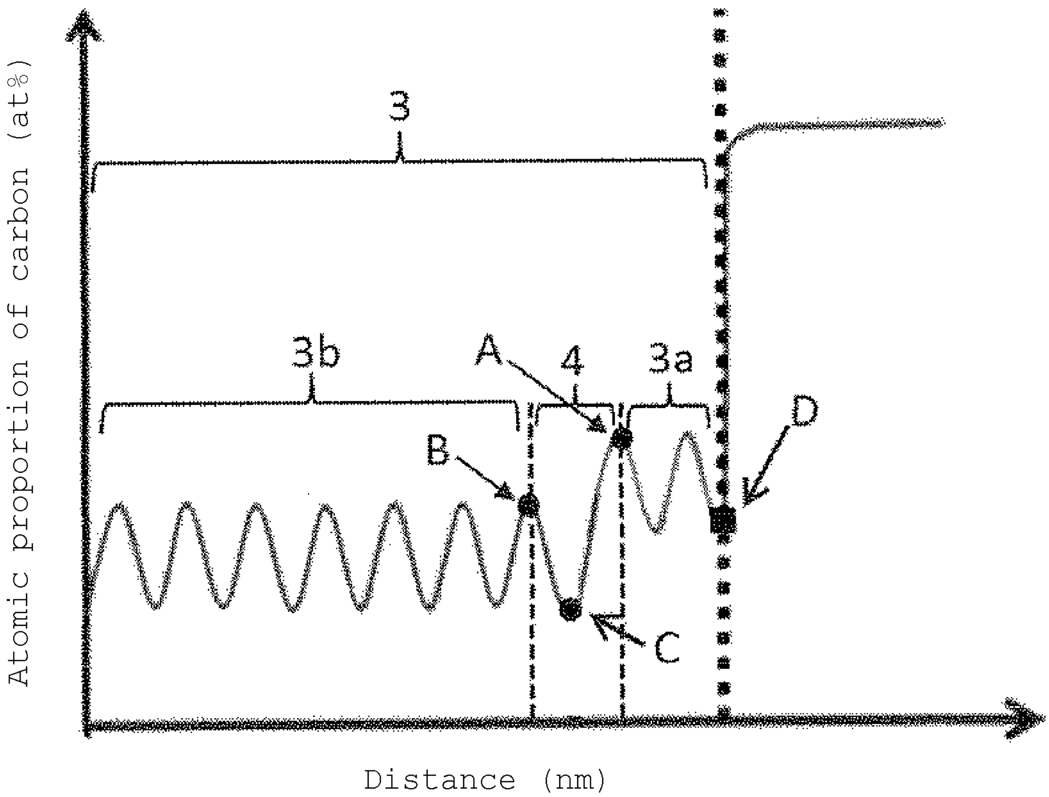

FIG. 3

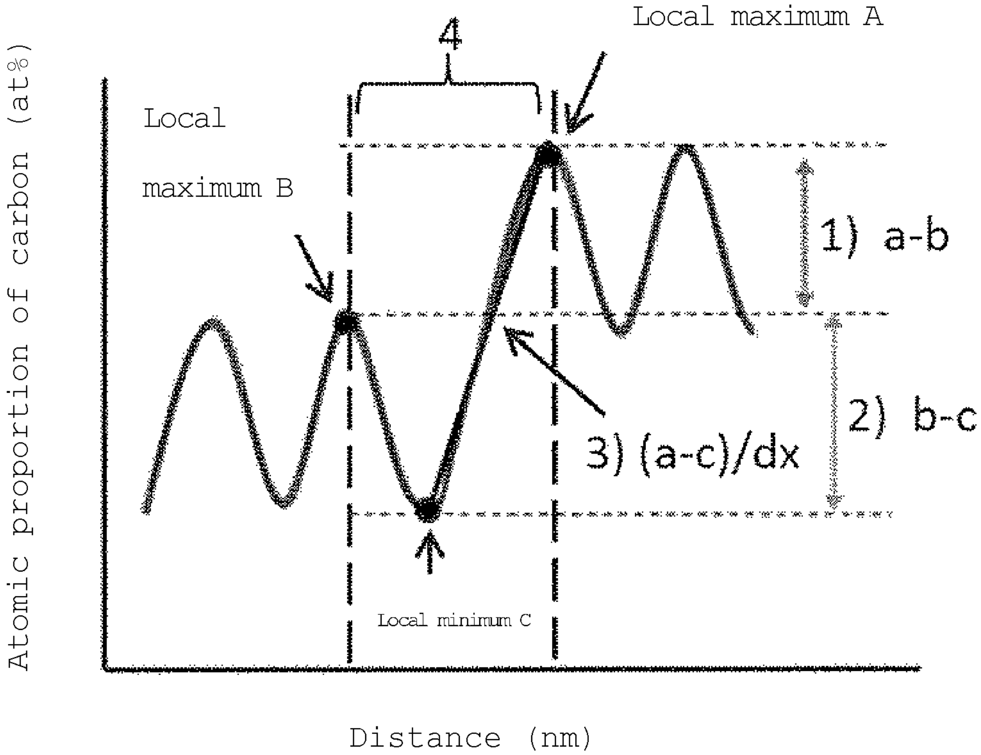
4
Local maximum A
Local
maximum B
1) a-b
2) b-c
3) (a-c)/dx
Local minimum C
Atomic proportion of carbon (at%)
Distance (nm)

FIG. 4

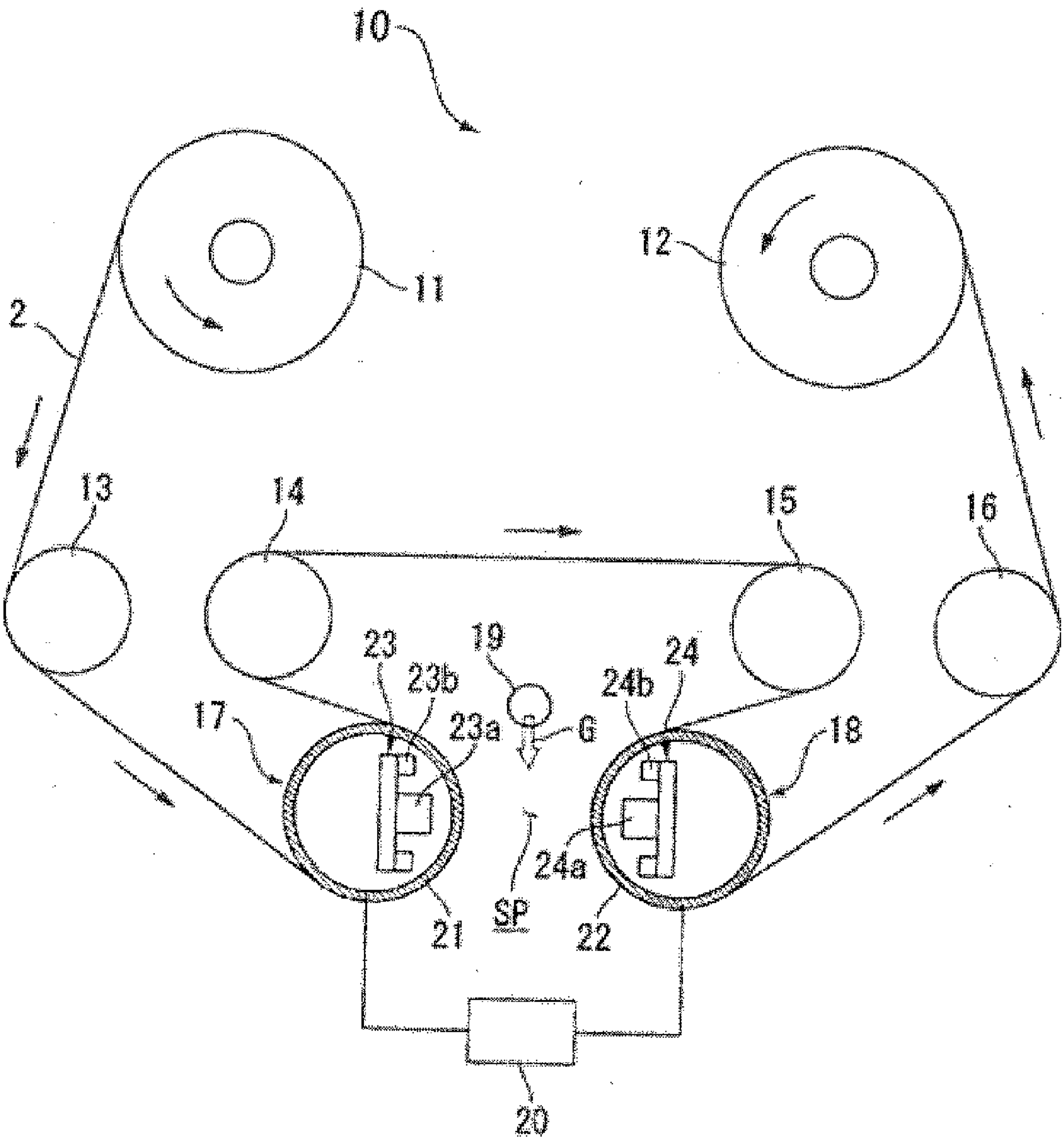

FIG. 5

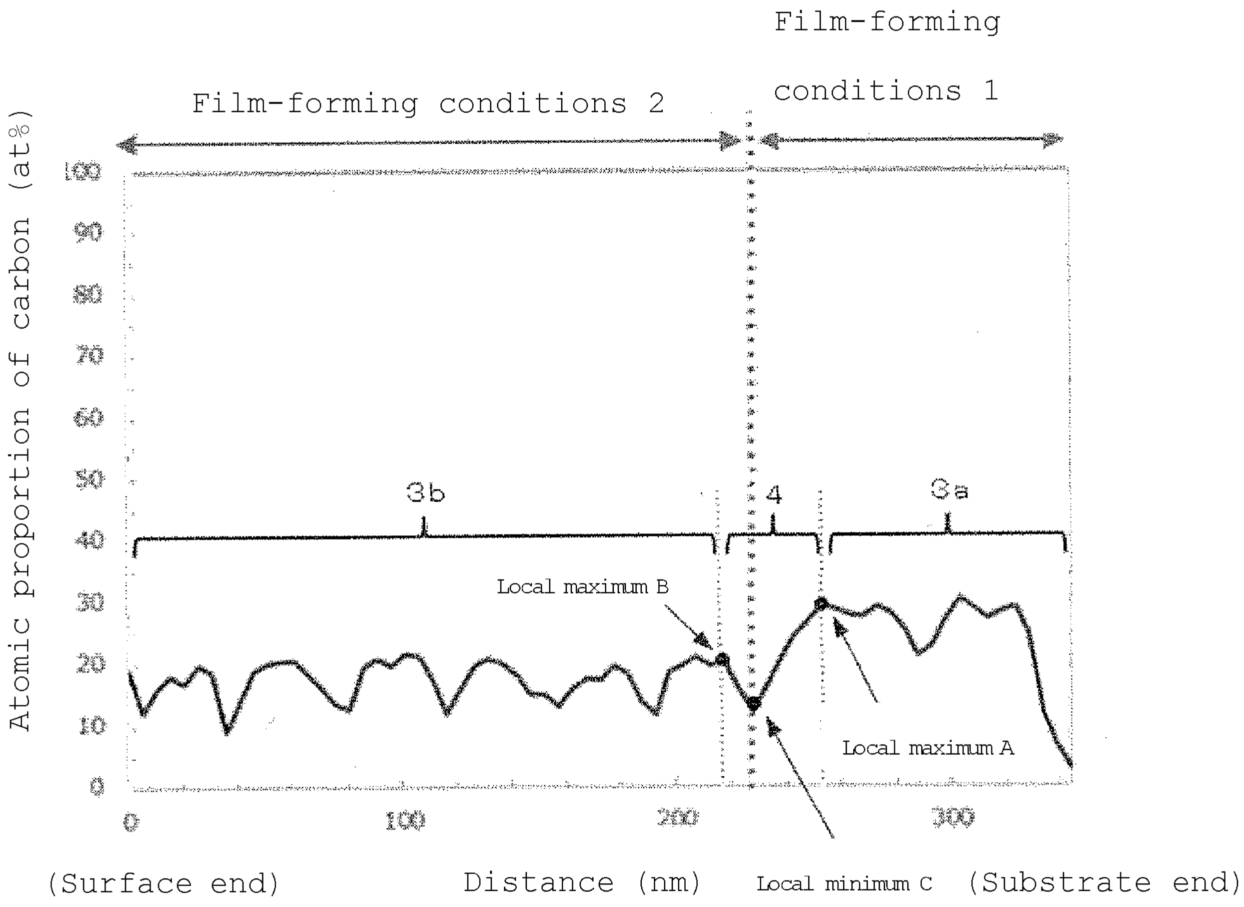
Film-forming conditions 1
Film-forming conditions 2
Atomic proportion of carbon (at%)
100
90
80
70
60
50
40
30
20
10
0
3b
4
3a
Local maximum B
Local maximum A
Local minimum C
0
100
200
300
(Surface end)
Distance (nm)
(Substrate end)

FIG. 6

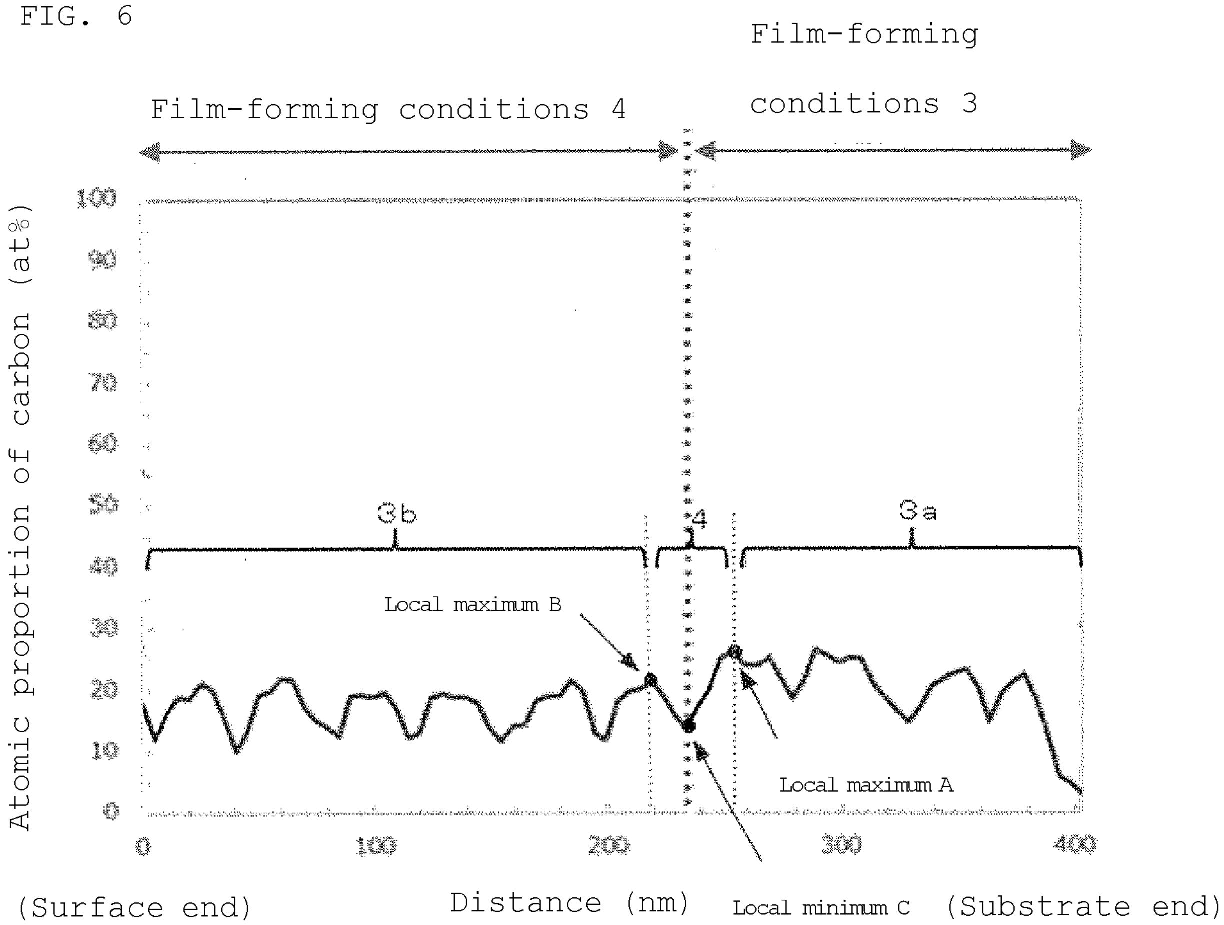
Film-forming conditions 4
Film-forming conditions 3
Atomic proportion of carbon (at%)
100
90
80
70
60
50
40
30
20
10
0
3b
4
3a
Local maximum B
Local maximum A
Local minimum C
0
100
200
300
400
(Surface end)
Distance (nm)
(Substrate end)

FIG. 7

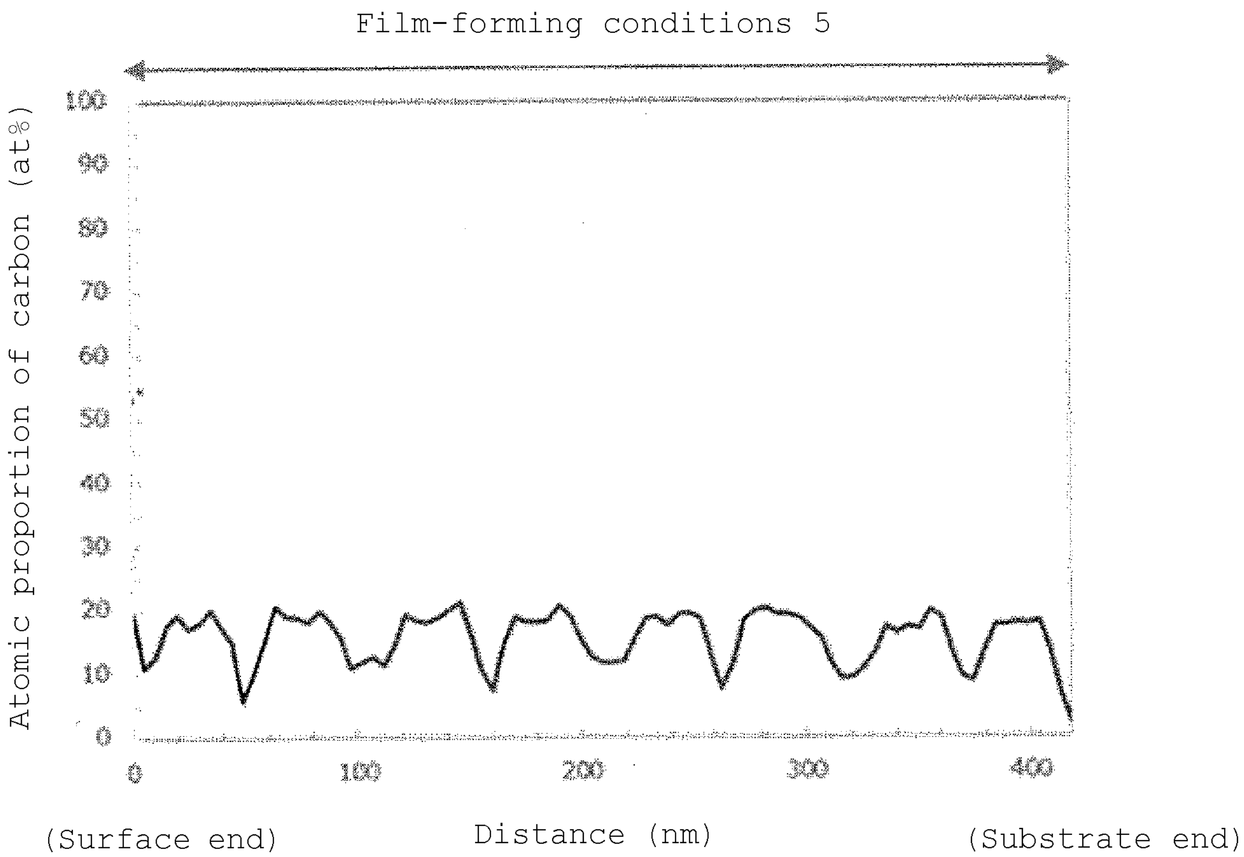
Film-forming conditions 5
Atomic proportion of carbon (at%)
100
90
80
70
60
50
40
30
20
10
0
0
100
200
300
400
(Surface end)
Distance (nm)
(Substrate end)

FIG. 8

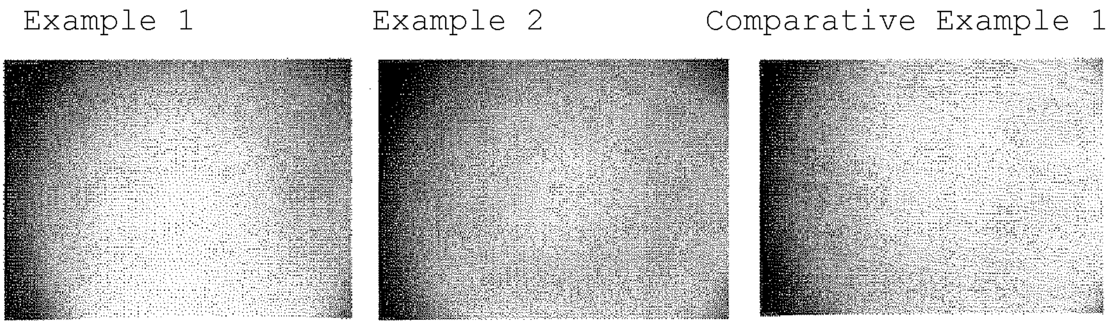

**INTERNATIONAL SEARCH REPORT**

International application No.
PCT/JP2018/030790

A. CLASSIFICATION OF SUBJECT MATTER
Int.Cl. B32B9/00(2006.01)i, C23C16/42(2006.01)i, H01L51/50(2006.01)i, H05B33/02(2006.01)i, H05B33/04(2006.01)i, H05B33/14(2006.01)i

According to International Patent Classification (IPC) or to both national classification and IPC

B. FIELDS SEARCHED

Minimum documentation searched (classification system followed by classification symbols)
Int.Cl. B32B9/00, C23C16/42, H01L51/50, H05B33/02, H05B33/04, H05B33/14

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2015-206096 A (KONICA MINOLTA, INC.) 19 November 2015, claim 1, paragraph [0151], gas barrier film 6, fig. 4 (Family: none) | 1, 3<br>2 |
| A | WO 2015/107702 A1 (KONICA MINOLTA, INC.) 23 July 2015, claim 1, paragraphs [0098], [0152]-[0159], fig. 3 (Family: none) | 1-3 |
| P, A | WO 2018/101026 A1 (KONICA MINOLTA, INC.) 07 June 2018, claim 1, paragraphs [0023], [0025], fig. 2 (Family: none) | 1-3 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 September 2018 (20.09.2018) | 02 October 2018 (02.10.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2013146964 A